Europäisches Patentamt

European Patent Office

Office européen des brevets

(19)

(11) Veröffentlichungsnummer: **0 143 375**
**B1**

(12) **EUROPÄISCHE PATENTSCHRIFT**

(45) Veröffentlichungstag der Patentschrift: **06.02.91**

(21) Anmeldenummer: **84113481.0**

(22) Anmeldetag: **08.11.84**

(51) Int. Cl.⁵: **H 03 F 1/30,** H 03 F 3/30

(54) **Transformatorlose Gegentaktendstufe.**

(30) Priorität: **29.11.83 DE 3343110**

(43) Veröffentlichungstag der Anmeldung:
**05.06.85 Patentblatt 85/23**

(45) Bekanntmachung des Hinweises auf die
Patenterteilung:
**06.02.91 Patentblatt 91/06**

(84) Benannte Vertragsstaaten:
**BE DE FR GB IT LU NL SE**

(56) Entgegenhaltungen:
**DE-A-2 822 037**
**FR-A-2 301 948**
**US-A-3 553 599**
**US-A-3 974 400**
**US-A-4 237 425**

(73) Patentinhaber: **Deutsche Thomson-Brandt
GmbH
Hermann-Schwer-Strasse 3 Postfach 1307
D-7730 Villingen-Schwenningen (DE)**

(72) Erfinder: **Koblitz, Rudolf, Dr. Ing.
Johann-Jakob-Rieggerstrasse 12A
D-7730 Villingen-Schwenningen (DE)**

Courier Press, Leamington Spa, England.

## Beschreibung

Die Erfindung geht aus von einer transformatorlosen Gegentaktendstufe mit komplementären Endstufentransistoren mit einer Schaltungsanordnung zur automatischen Einstellung des Ruhestromes durch eine zwischen die Basen der Endstufentransistoren geschaltete Vorspannungsquelle.

Derartige Schaltungsanordnungen benötigen zwecks Beseitigung von Übernahmeverzerrungen beim Nulldurchgang des Laststromes durch die im Gegentakt betriebene Endstufen d.h. zur Verringerung des Klirrfaktors der Endstufen einen diese durchfließenden Querstrom als Ruhestrom. Dieser Ruhestrom wird fest eingestellt und soll im Interesse eines guten Wirkungsgrades möglichst gering sein. Diese Einstellung erfordert einen guten Kompromiss zwischen gutem Wirkungsgrad und geringem Klirrfaktor der Endstufe. Bei fest eingestelltem Ruhestrom besteht die Gefahr einer thermischen Instabilität, die zur Zerstörung der Leistungstransistoren führen kann. Die Einstellung des Ruhe- bzw. Leerlaufstroms erfolgt über die Vorspannung der Endstufentransistoren, deren Einstellung sehr kritisch ist, da die $U_{BE}/I_C$ — Kennlinie expotentiell ansteigt und eine starke Temperaturabhängigkeit aufweist. Es werden deshalb für die Erzeugung der Vorspannung temperaturabhängige Elemente wie z.B. Heißleiter, Dioden oder Transistoren eingesetzt, welche die gleiche thermische Abhängigkeit wie die Endtransistoren besitzen und die in engem thermischen Kontakt mit den Endstufentransistoren gebracht werden müssen.

Diese Maßnahmen besitzen einige beachtliche Nachteile, insbesondere, wenn die Schaltungsanordnung mit diskreten Bauelementen aufgebaut wird. Um Exemplarstreuungen der Einzelelemente zu kompensieren, ist ein teurer Ableichvorgang in der Produktion notwendig. Die thermische Kopplung zwischen den Leistungstransistoren und dem Temperaturfühlelement kann nie vollkommen sein, so daß keine absolute thermische Stabilität garantiert werden kann. Die Folge ist ein Hochlaufen des Leerlaufstroms, was zunächst den Wirkungsgrad verschlechtert. Bei weiterer Erhöhung können die Endstufentransistoren zerstört werden. Spannungsschwankungen der Versorgungsspannung können den Leerlaufstrom und die thermische Stabilität beeinflußen, was bei Audioverstärkern mit ungeregelter Versorgungsspannung besondere Probleme aufwirft. Die genannten Nachteile gelten insbesondere auch für hybride Gegentaktsysteme, bei denen die Steuereinheit bevorzugt monolithisch integriert ist und die Endstufenelemente diskret aufgebaut sind (z.B. die integrierte Schaltung LM 391 von der Firma National Semiconductor). Selbst bei integrierten Leistungsverstärkern lassen sich diese Probleme nicht vollständig beseitigen.

Mit Hilfe einer automatischen Leerlaufstromeinstellung können die geschilderten Nachteile jedoch völlig beseitigt werden. In der DE—C—27 25 064 ist eine Schaltungsanordnung beschrieben, bei der der Kollektorstrom eines Gegentakttransistors geregelt wird. Die beschriebene Schaltung erzeugt jedoch einen relativ hohen Leerlaufstrom und ist für Gegentaktendstufen, die einen guten Wirkungsgrad besitzen sollen, d.h. für im A-B-Betrieb arbeitende Endstufen mit kleinem Ruhestrom nicht anwendbar.

In der DE—A—26 14 399 wird eine im A-B-Betrieb arbeitende Endstufe mit kleinem Leerlaufstrom beschrieben, die einen guten Wirkungsgrad besitzt, die jedoch einen hohen Schaltungsaufwand aufweist, der selbst für eine monolithische Integration zu hoch ist.

In der DE—B—28 22 037 ist eine Schaltungsanordnung zur Regelung des Arbeitspunktes bei einem Gegentakt-B-Verstärker beschrieben, bei der der Ruhestrom in einem Zweig der Gegentaktendstufe erfasst wird. Diese Erfassung des Ruhestroms berücksichtigt jedoch nicht gleichzeitig den durch die Lastimpedanz der Gegentaktendstufe fließenden Laststrom.

Weiter ist eine Schaltungsanordnung bekannt, die die Lastströme in einer Gegentaktendstufe erfasst, wobei bei zu hohem Laststrom die Vorspannungsquelle nachgeregelt wird, um eine Zerstörung der Endstufentransistoren zu vermeiden (US—A—4,237,425). Hierzu werden zwei Stromgeneratoren eingesetzt, die von zwei in die positive und in die negative Ausgangsleitung der Gegentaktendstufe angeordneten Meßschaltungen zur Messung des positiven und negativen Laststroms eingeschaltet werden. Die Stromgeneratoren sind auf einen Integrator geschaltet, der die Vorspannung für die Endstufen liefert. Da beide Zweige berücksichtigt werden, ist für die optimale Wirkung der Schaltung ein genauer Gleichlauf zwischen den beiden Stromgeneratoren unbedingte Voraussetzung. Dadurch wird die Schaltung sehr aufwendig.

Der Erfindung liegt die Aufgabe zugrunde, die oben geschilderten Nachteile vollständig zu beseitigen. Diese Aufgabe wird durch die im Patentanspruch angegebene Erfindung gelöst.

Die Erfindung bringt den Vorteil, daß die Einstellung des Ruhestroms mit Hilfe einer Regelschleife erfolgt, welche bei beliebigen Aussteuerungen und bei beliebigen Lastimpedanzen einwandfrei arbeitet, wobei ein Minimum an schaltungstechnischem Aufwand erforderlich ist. Es ist kein manueller Abgleich mehr erforderlich. Durch die automatische Regelung ist eine absolute thermische Stabilität der Schaltung gewährleistet. Es ist kein Temperaturfühlelement notwendig. Die beiden Leistungstransistoren können sogar unterschiedliche Temperaturen besitzen.

Nachstehend sei das Wesentliche der Erfindung mit Hilfe der Zeichnung erläutert.

Figur 1 zeigt eine vereinfachte Schaltung der Erfindung;

Figuren 2 und 3 zeigen Stromdiagramme zur Erläuterung der Wirkungsweise der Schaltung nach Figur 1;

Figur 4 zeigt eine detaillierte Schaltung der Erfindung.

Zunächst sei das Prinzip der Erfindung in einem vereinfachten Schaltbild beschrieben. Mit 1 und 2 sind die beiden komplementären Endstufentransistoren bezeichnet, die mit ihren Emittern zusammengeschaltet sind, an denen die Lastimpedanz 3 angeschlossen ist. Die Endstufentransistoren sind mit Hilfe einer Vorspannungsquelle 4 vorgespannt. Die Eingangsspannung wird in üblicher Weise über den Anschluß 5 einem Vorverstärker 6 über einen Kondensator 7 zugeführt. Der Eingang des Vorverstärkers 6 ist über den Widerstand 8 geerdet. Der Ausgang des Vorverstärkers ist mit den Basen der Endstufentransistoren 1 und 2 verbunden. Vom Ausgang der Endstufe gelangt eine Gegenkopplungsspannung über den Widerstand 9 an den invertierenden Eingang des Vorverstärkers 6, der über den Widerstand 10 mit dem in Serie zu diesem geschalteten Kondensator 11 geerdet ist.

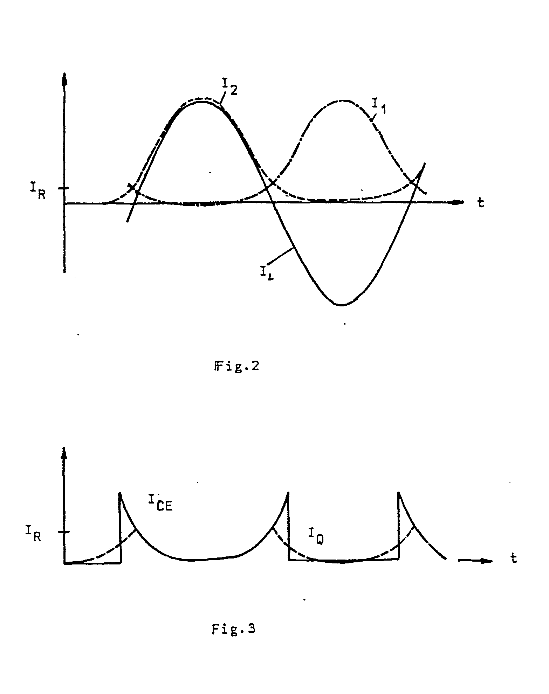

Es soll nun das Prinzip der automatischen Ruhestromeinstellung in Verbindung mit den Figuren 2 und 3 beschrieben werden. In die Kollektorleitung des einen Transistors 1 der Endstufe ist ein Widerstand 12 geschaltet, an welchem eine Spanung $U_1$ infolge des durch diesen fließenden Stromes entsteht. Die Kollektorleitung des anderen Transistors 2 ist ebenfalls ein Widerstand 13 zum gleichen Zweck geschaltet. Das mit dem Kollektor des Transistors 2 verbundene Ende des Widerstandes 13 liegt am positiven Eingang eines Spannungskomparators 14, dessen negativem Eingang eine Referenzspannung Us zugeführt ist. Bei Überschreiten eines durch die Referenzspannung vorgegebenen Laststromes durch die Impedanz 3, der bei aktivem Transistor 2 auch durch den Widerstand 13 fließt, wirkt der an dem Widerstand 12 durch den Ruhestrom IR der Endstufe verursachte Spannungsabfall $U_1$ über den symbolisch dargestellten Schalter 15 auf eine Stromquelle 16 ein. Das bedeutet, daß immer dann, wenn in dem einen Zweig der Endstufe 2 der Laststrom IL fließt, der Ruhestrom im anderen Zweig der Endstufe 1 gemessen und ausgewertet wird. Die Größe des Spannungsabfalls $U_1$, d.h. die Größe des Stromes $I_1$ während der Lastphase von Endtransistor 2, bestimmt den Entladestrom eines Kondensators 16, der von einer Konstantstromquelle 17 aufgeladen wird. Je nach Größe des Entladestroms, d.h. in Abhängigkeit vom sich ergebenden Ruhestrom der Endstufe verändert sich die am Kondensator 16 stehende Spannung. Die Spannung beeinflußt bzw. steuert die Vorspannungsquelle 4 in der Weise, daß mit steigendem Ruhestrom die Vorspannung UV kleiner wird, wodurch der Ruhestrom heruntergegegelt wird. Das Prinzip dieser Regelung benötigt keine Information über den Spannungswert an der Lastimpedanz 3. Es werden nur Ströme ausgewertet. Die Lastimpedanz 3 kann daher einen beliebigen komplexen Widerstand beliebigen komplexen Widerstand besitzen, wie dies zum Beispiel bei Lautsprechern der Fall ist, ohne daß dadurch die Ruhestromregelung in irgend einer Weise beeinflußt wird.

Selbstverständlich können die durch die Widerstände 12 und 13 gemessenen Ströme auch auf andere Weise detektiert werden.

In Figur 2 sind die verschiedenen Ströme $I_1$ durch den Transistor 1, $I_2$ durch den Transistor 2 sowie $I_L$ durch die Impedanz 3 aufgetragen. Im Nulldurchgang des Laststromes IL ergibt sich ein Ruhestrom IR des Querstroms IQ, der zusätzlich zum Lastrom IL durch die Transistoren 1 und 2 fließt. In Figur 3 ist der Verlauf des Entladestroms ICE zusammenmit dem Querstrom IQ aufgezeichnet.

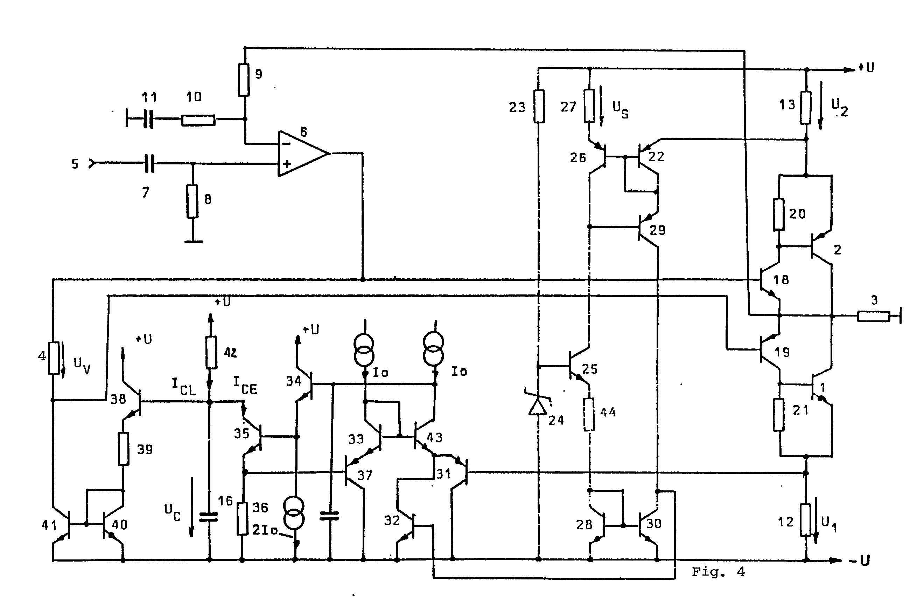

Die Wirkungsweise der angemeldeten leicht in integrierter Technik herstellbaren Schaltung sei mit Hilfe der Figur 4 beschrieben.

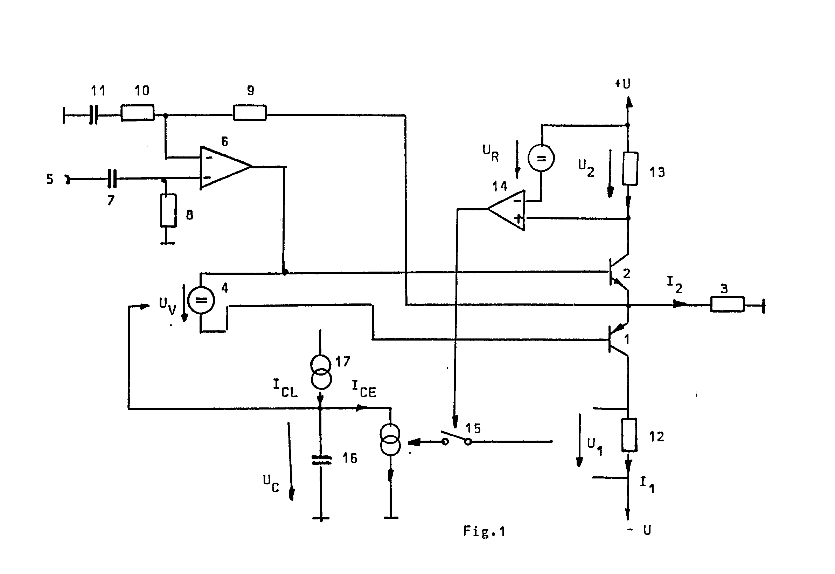

Die in dieser Figur mit gleichen Bezugszeichen versehenen Bauelement entsprechen den in Figur 1 bereits beschriebenen. Die Ausgangsspannung des Vorverstärkers 6 gelangt hier noch über Treibertransistoren 18 und 19 an die Endstufentransistoren 1 und 2. Die Arbeitswiderstände der Treibertransistoren 18 und 19 sind mit 20 und 21 bezeichnet. An dem Widerstand 12 wird die Spannung $U_1$ gemessen, die während der aktiven Phase des Transistors 2 ein Maß für den Querstrom IQ ist. Die Auswertung dieser Spannung erfolgt, sobald der durch den Laststrom IL verursachte Spannungsabfall am Widerstand 13 so groß ist, daß er den Referenzpegel Us unterschreitet. Der Referenzpegel Us am Widerstand 27 wird erzeugt durch die Konstantstromquelle mit dem Widerstand 23, der Zenerdiode 24 und den Transistoren 25 und 28 und dem Widerstand 44. Die Bauelemente 22, 26 und 29 bilden einen Stromspiegel. Wenn der Spannungsabfall an dem Widerstand 13 groß genug ist, wird der gespiegelte Strom durch den Transistor 29 kleiner als der durch den Stromspiegel 28, 30 erzeugte Strom, so daß der Transistor 32 aus der Sättigung kommt. Dieser entspricht dem Schalter 15 im geschlossenen Zustand entsprechend der Prinzipschaltung nach Figur 1. Die Transistoren 31, 37, 33, 43 und 34 bilden einen Operationsverstärker, dessen nichtinvertierender Eingang die basis des Transistors 31 und dessen invertierender Eingang die Basis des Transistors 37 ist. Durch den Transistor 35 ist dieser Verstärker rückgekoppelt, so daß, wenn der Transistor 32 nichtleitend ist, die Spannung am Widerstand 36 der Spannung $U_1$ am Widerstand 12 entspricht. Der Kollektorstrom des Transistors 35 ($=I_{CE}$) entspricht dann näherungsweise dem Strom durch den Widerstand 36. Es handelt sich bei der aus den Transistoren 31, 37, 33, 43, 34, 35 und dem Widerstand 36 gebildeten Anordnung um einen Spannungs-Strom-Wandler. Der Transistor 35 steuert je nach gemessener Spannung $U_1$ den Entladestrom ICE für den von einer Quasi-Konstant-Stromquelle 42 aufgeladenen Kondensator 16. Die Spannung am Kondensator 16 wirkt über die aus den Transistoren 38 dem Widerstand 39 und die Diode 40 und den Transistor 41 gebildete Stromspiegelschaltung auf die Vorspannungsquelle 4. Steigt z.B. der Ruhestrom an, wird der Kondensator 16 entladen, es fließt weniger Strom durch den Widerstand 4 als Vorspannungsquelle, so daß die Vorspannung absinkt, was eine Verringerung des Ruhestroms in gewollter Wiese zur Folge hat. Hierdurch ist die Regelschleife geschlossen. Die beschriebene Schaltungsanordnung ist auf sämliche Serien Gegentaktverstärker anwendbar, deren Ruhestromeinstellung über eine Gleichspannungseinstellung erfolgt.

**Patentanspruch**

Transformatorlose Gegentaktendstufe (1, 2) mit komplementären Endstufentransistoren und einer Schaltungsanordnung zur automatischen Einstellung des Ruhestromes mit Hilfe einer in den einen Zweig der Gegentaktendstufe angeordneten Strommeßeinrichtung (12) zur Erfassung des durch die Gegentaktendstufe fließenden Ruhestromes und mit einer zwischen die Basen der Endtransistoren geschalteten Vorspannungsquelle (4), dadurch gekennzeichnet, daß in den anderen Zweig der Gegentaktendstufe (1, 2) eine weitere Strommeßeinrichtung (13) zur Messung des durch die Gegentaktendstufe (1, 2) fließenden Laststromes (I2) vorgesehen ist, welche bei Überschreiten eines vorgebbaren Grenzwertes des Laststromes (I2) über eine Schaltstufe (15) einen von der ersten Strommeßeinrichtung (12) zur Erfassung des durch die Gegentaktendstufe (1, 2) fließenden Ruhestromes (IR) einen diesem proportionalen Entladestrom (ICE) eines von einer Konstantstromquelle (17) mit einem Strom (ICL) aufladbaren Kondensators (16) steuert, dessen Ladespannung (Uc) die Vorspannungsquelle (4) für die Gegentaktendstufe (1, 2) regelt.

**Revendication**

Etage final push-pull (1, 2) sans transformateur comprenant des transistors complémentaires d'étage final et un circuit pour la régulation automatique du courant de repos à l'aide d'un élément de mesure de courant (12) monté dans l'une des branches de l'étage final push-pull et destiné à détecter le courant de repos parcourant l'étage final push-pull, ainsi qu'une source de tension de polarisation (4) commutée entre les bases des transistors finals, caractérisé en ce que, pour mesurer le courant de charge (I2) parcourant l'étage final push-pull (1, 2), un autre élément de mesure de courant (13) est prévu sur l'autre branche de l'étage final push-pull (1, 2), qui, en cas de dépassement d'une valeur limite donnée par le courant de charge (I2), commande par un étage de commutation (15) un courant de décharge (ICE) proportionnel au courant de repos (IR) parcourant l'étage final push-pull (1, 2) et détecté par le premier élément de mesure de courant (12), qui est fourni par un condensateur (16) chargé avec le courant (ICL) délivré par une source de courant constant (17), et dont la tension de charge (Uc) règle la source de tension de polarisation (4) pour l'étage final push-pull (1, 2).

**Claim**

A transformerless push-pull output stage (1, 2) with complementary output stage transistors and a circuit arrangement for automatically setting the quiescent current with the aid of a current measuring device (12) which is arranged in one branch of the push-pull output stage, for detecting the quiescent current flowing through the push-pull output stage and having a bias voltage source (4) which is connected between the bases of the output transistors, characterised in that in the other branch of the push-pull output stage (1, 2) a further current measuring device (13) is provided for measuring the load current (I2) flowing through the push-pull output stage (1, 2), said device (13) controlling, via a switching stage (15) of the first current measuring device (I2) for detecting the quiescent current (IR) which flows through the push-pull output stage (1, 2), when a predetermined limit value of the load current (I2) is exceeded, a discharge current (ICE) of a capacitor (16) which may be charged up by a constant current source (17) with a current (ICL), which discharge current is proportional to the quiescent current (IR), the charge voltage (Uc) of the said capacitor (16) regulating the bias voltage source (4) for the push-pull output stage (1, 2).

Fig.1

Fig.2

Fig.3

Fig. 4

EP 0 143 375 B1

3